# EUROPÄISCHE PATENTSCHRIFT

(11) **EP 0 594 144 B1**
(45) Veröffentlichungstag und Bekanntmachung des Hinweises auf die Patenterteilung: **01.07.1998**
(21) Anmeldenummer: 93116933.8
(22) Anmeldetag: 20.10.1993
(51) Int. Cl.: H04L 12/40

(54) **Bussystem**
Bussystem
Système à bus

(30) Priorität: 23.10.1992 DE 4235775; 09.11.1992 DE 4237789; 03.07.1993 DE 4322249
(43) Veröffentlichungstag der Anmeldung: 27.04.1994
(73) Patentinhaber: Marquardt GmbH, 78604 Rietheim-Weilheim (DE)
(72) Erfinder: Müller, Karl, D-78628 Rottweil-Neufra (DE)
(74) Vertreter: Patentanwälte Eisele, Otten & Roth

(56) Entgegenhaltungen:
- DE-A- 3 609 487
- DE-A- 3 627 638
- DE-A- 3 717 886
- DE-A- 3 743 847

## Beschreibung

Die Erfindung betrifft ein Bussystem nach dem Oberbegriff des Patentanspruchs 1.

Auf allen Gebieten der modernen Technik findet ein zunehmender Einsatz der Elektronik statt. Dies gilt insbesondere auch für die moderne Automobiltechnik mit einer stetigen Zunahme elektrischer Komponenten, Motoren und Aggregaten sowie elektronischer Systeme, die wenigstens teilweise durch Schalter und Bedienelemente betätigt werden müssen. Beispielsweise gilt dies für das Karosseriesystem mit Leuchten, Zentralverriegelung, Türsicherungen, Fensterheber, Rückspiegelverstellung, Heizungs- und Klimaanlage, Gurt- und Sitzverstellung, usw.. Da die Schalter oder Bedienelemente im Bereich des Benutzers und damit in der Regel entfernt vom jeweiligen elektronischen System angeordnet werden müssen, ist eine umfangreiche Verdrahtung der jeweiligen Schalter und Bedienelemente erforderlich. Allein im Bereich des Armaturenbretts eines modernen Kraftfahrzeuges sind oft mehr als 100 Kabel und Steckverbindungen zum Anschluß derartiger Schalter und Bedienelemente unterzubringen. Hinzu kommt, daß moderne Fahrzeug-Sicherheitssysteme, wie z. B. Bremsüberwachung, Antiblockiersystem, Antriebsschlupfregelung, usw. sowie elektronische Motor- und Getriebesteuerung eine aufwendige Sensorik erfordern, die ebenfalls verdrahtet werden muß. Eine solche konventionelle Verdrahtung hat damit einen kaum noch beherrschbaren Umfang erreicht.

Aufgrund dieser immer umfangreicher werdenden Verdrahtung nehmen die Probleme, die durch elektromagnetische Störabstrahlungen der konventionellen Verdrahtungsleitungen sowie umgekehrt durch Aufnahme von Störsignalen in den Verdrahtungsleitungen auftreten, immer mehr zu.

Um hier Abhilfe zu schaffen, ist es im Fahrzeugbau bekannt geworden, eine Vernetzung von elektronischen Steuergeräten mittels eines Bussystems zu realisieren, wodurch beliebig viele elektronische Steuersysteme oder Steuergeräte im Kraftfahrzeug über einen gemeinsamen Bus miteinander verknüpft werden und in einen Datenaustausch treten können. Ein derartiges Bussystem ist beispielsweise der bekannte CAN-Bus (CAN = Controller Area Network). Nachteilig ist hierbei, daß es sich um eine sehr aufwendige und kostenintensive Ankopplung der Steuersysteme und -geräte an das Bussystem handelt, die für die Mehrzahl der im Kraftfahrzeug befindlichen Bedienelemente völlig überdimensioniert ist. Außerdem werden spezielle und damit teuere Steuergeräte für dieses Bussystem benötigt.

Aus der Rechnertechnik ist weiter bekannt, einen Bus mit einem übergeordneten Hauptbus zu verbinden. So zeigt die DE-OS 37 43 847 die Ankopplung mehrerer der Erfassung von Meßgrößen dienender Sensormodule an einen Meßbus, bei dem es sich um einen parallelen Mikroprozessor-Bus handelt, wobei die Sensormodule mit einem Zentralrechner verbunden sind und über eine Adresse vom Zentralrechner angesprochen werden. Mehrere dieser Zentralrechner kommunizieren wiederum mit einem übergeordneten Hostrechner über einen eigenen Hauptbus, womit ein flexibles Prozeßmeßdatenerfassungs- und -verarbeitungssystem geschaffen werden soll.

Nachteilig ist jedoch, daß es sich auch hier um ein aufwendiges System handelt, das speziell an die Aufgaben der Prozeßdatenverarbeitung angepaßt ist. Ein derartiges System ist für die Anforderungen an die Mehrzahl der Bedienelemente im Kraftfahrzeug ebenfalls überdimensioniert und nicht kostengünstig einzusetzen. Insbesondere ist das System nicht zur Ankopplung von binär organisierten Sensoren, Aktoren und mechanischen Schaltern in einem Bussystem geeignet.

Der Erfindung liegt die Aufgabe zugrunde, ein Bussystem derart auszugestalten, daß eine einfache und kostengünstige Verbindung von Sensormodulen, wie Bedienelementen in einem Kraftfahrzeug, ermöglicht wird. Insbesondere soll eine Ankopplung von binär organisierten Sensoren, Aktoren und mechanischen Schaltern in einem Bussystem mit einer eigenen autonomen Steuerung mittels eines Busmaster-Gerätes möglich sein. Ist ein übergeordneter Hauptbus vorhanden, so soll weiter eine Ankopplung des Bussystems an den Hauptbus mittels offener Schnittstellen über das Busmaster-Gerät möglich sein.

Diese Aufgabe wird bei einem gattungsgemäßen Bussystem durch die kennzeichnenden Merkmale des Anspruchs 1 gelöst.

Weitere Ausgestaltungen der Erfindung sind Gegenstand der Unteransprüche.

Die mit der Erfindung erzielten Vorteile bestehen insbesondere darin, daß gegenüber den bekannten Bussystemen ein sehr einfaches und auch flexibles System zur Ankopplung von Sensormodulen zu einem Netzwerk erfolgt. Dabei können als Sensormodule eine Vielzahl von Einzelschalter, auch herkömmliche mechanische Schalter verwendet werden. Die Ankopplung solcher Schalter erfolgt direkt an den Bus, so daß das binäre Schaltsignal des einzelnen Schalters auf kürzestem Weg in das Bussystem integrierbar ist. Hierdurch werden lange elektrische Leitungen in herkömmlicher Bauweise eingespart. Weiterhin werden die Vorteile der Busvernetzung in vollem Umfang genutzt.

Weiter vorteilhaft ist bei den mittels des Bussystems miteinander verbundenen Sensormodulen deren Adressierbarkeit und auch Tesbarkeit über den Bus. Man erhält beim erfindungsgemäßen Bussystem eine dezentrale Intelligenz ohne Volumen- und Kostenanstieg bei minimalem Verkabelungsaufwand. Es erfolgt zudem eine weitgehende Störunterdrückung von EMV-Einflüssen.

Die Erfindung weist schließlich noch den Vorteil auf, daß sich das Bussystem auf einfache Weise in übergeordnete, marktübliche Bussysteme integrieren läßt. So können die wesentlichen Steuergeräte, wie das sicherheitsrelevante Antiblockiersystem, die Bremsüberwachung, das Motormanagement, usw., über einen gemeinsamen, aufwendigeren Hauptbus, beispielsweise den CAN-Bus, verbunden sein. Die Elemente im Kraftfahrzeug, an die geringere Anforderungen gestellt werden, können andererseits mittels des untergeordneten, einfacheren und damit kostengünstigeren Bussystems gekoppelt sein. Ein Datenaustausch zwischen dem Bussystem und dem übergeordneten Hauptbus wird über offene Schnittstellen ermöglicht.

Ausführungsbeispiele der Erfindung sind in den Zeichnungen dargestellt und werden im folgenden näher beschrieben. Es zeigen
- Fig. 1: schematisch einen Ausschnitt aus einer Karosserie eines Kraftfahrzeugs mit der Anordnung des Bussystems,
- Fig. 2: ein Blockschaltbild zum Bussystem,
- Fig. 3: Bussignale bei der Übertragung vom Steuergerät zum Sensormodul,
- Fig. 4: Bussignale bei der Übertragung vom Sensormodul zum Steuergerät,
- Fig. 5: ein Blockschaltbild zum Aufbau der Buslogik,
- Fig. 6: ein aus einem Schnappschalter bestehendes Sensormodul mit teilweise auf gebrochenem Gehäuse und
- Fig. 7: ein Blockschaltbild für ein Sensormodul mit einem Induktivsensor.

Das erfindungsgemäße Bussystem besteht aus wenigstens einem Bus zur Übertragung von Signalen und läßt sich vorteilhafterweise in einem Kraftfahrzeug einsetzen.

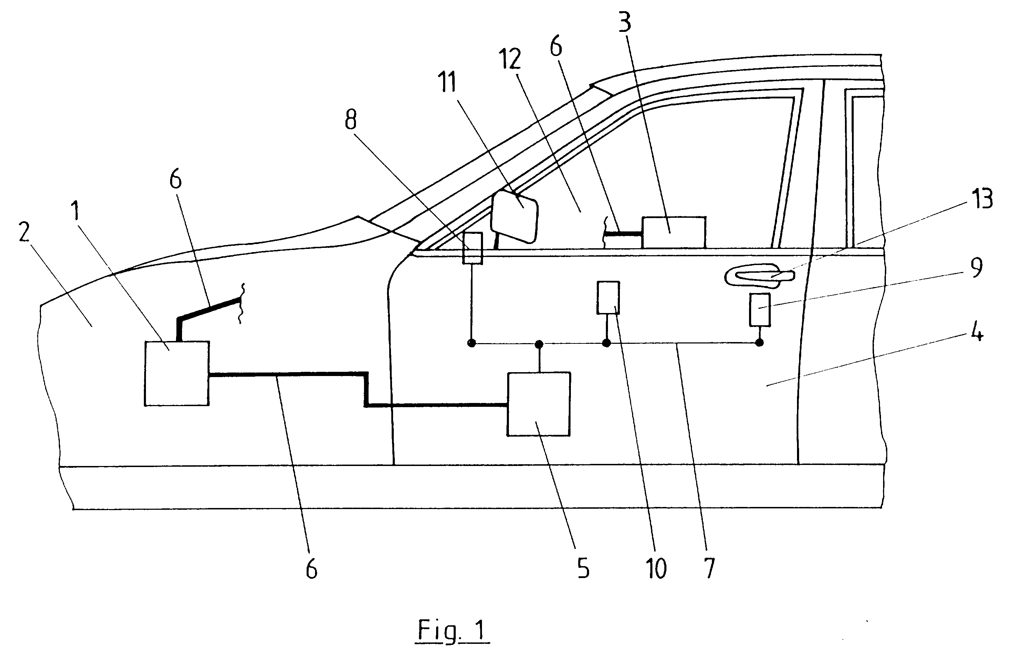

Wie in Fig. 1 näher zu sehen ist, ist ein Steuergerät 1 für die Motorelektronik im Motorraum 2, ein Schaltgerät 3 für mehrere Bedienschalter zur Steuerung der elektrischen Fensterheber und der Rückspiegelverstellung an der Innenseite der Autotür 4 oder gegebenenfalls in der Mittelkonsole und ein Steuergerät 5 für die Rückspiegelverstellung und Fensterheber in der Autotür 4 angeordnet. Diese Schalt- und Steuergeräte 1, 3, 5 sind über einen Hauptbus 6 zur Übertragung von Signalen miteinander verbunden. Bei dem Hauptbus 6 kann es sich um einen CAN-Bus handeln, wie er beispielsweise in der Literaturstelle Philips: CAN-Produkte für universelle Anwendungsfelder, Januar 1992 beschrieben wird. Selbstverständlich ist ein anderer Bus-Typ gleichermaßen verwendbar.

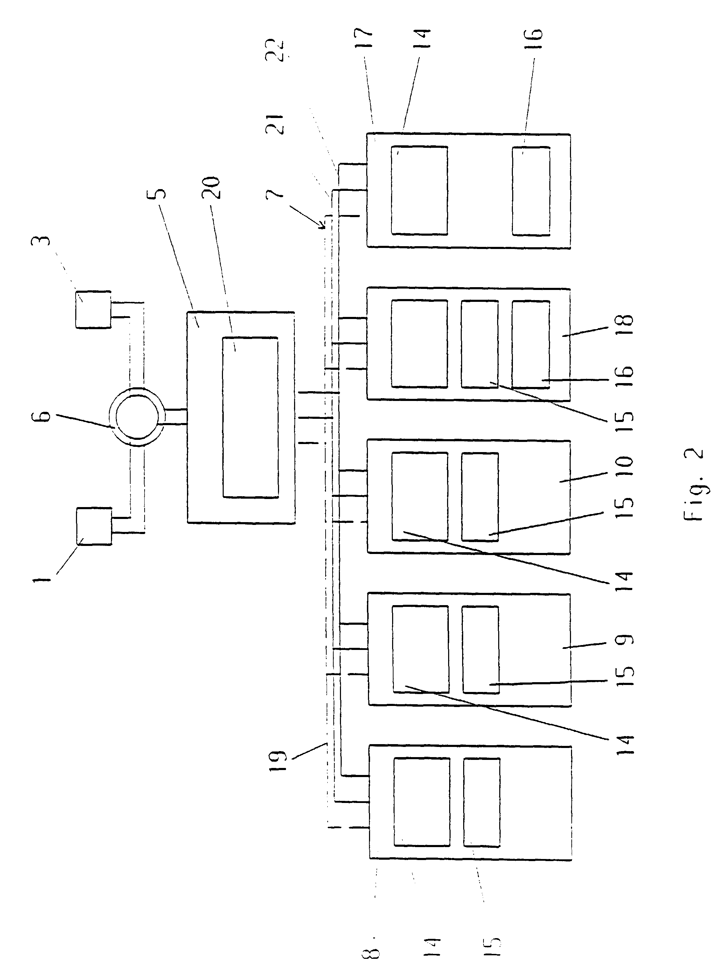

In der Autotür 4 befindet sich weiter ein Bus 7, der eine Verbindung zwischen einem Sensormodul 8 für die Rückspiegelverstellung, einem Sensormodul 9 für die Zentralverriegelung und einem Sensormodul 10 für die elektrischen Fensterheber herstellt. Diese Sensormodule 8, 9, 10 befinden sich am Rückspiegel 11 und dem Fenster 12 zur Feststellung der jeweiligen Endposition eines Betätigers und im Türschloß 13 für die Türschloßabfrage. Das Steuergerät 5 in der Autotür 4 ist als Busmaster-Gerät für die Steuerung der Signalübertragung auf dem Bus 7 ausgebildet, so daß Signale zwischen den Sensormodulen 8, 9, 10 und dem Steuergerät 5 übertragen werden können. Mittels des Busmaster-Gerätes 5 ist der Bus 7 unabhängig vom Hauptbus 6 steuerbar und zur Signalübertragung mit dem übergeordneten Hauptbus 6 über eine offene Schnittstelle, d. h. eine Schnittstelle mit festem, offengelegtem Protokoll, gekoppelt. Das gesamte Bussystem ist als prinzipielles Blockschaltbild in Fig. 2 dargestellt.

Wie aus Fig. 2 ersichtlich ist, bestehen die Sensormodule 8, 9, 10 jeweils aus einer integrierten Buslogik 14 und einem binär organisierten Sensor 15. Der Sensor 15 besitzt also zwei Statuszustände, so daß das Sensormodul 8, 9, 10 zur Erfassung binärer Schaltsignale dient. Anstelle eines Sensors 15 kann das Sensormodul, wie bei einem Sensormodul 17 gemäß einer weiteren Ausführung in Fig. 2 dargestellt ist, auch einen binär organisierten Aktor 16 besitzen, so daß das Sensormodul 17 zur Verarbeitung binärer Schaltsignale dient. Außerdem ist es auch möglich, daß das Sensormodul 18 in nochmals einer weiteren Ausführung sowohl einen Sensor 15 als auch einen Aktor 16 enthält. Bei einem binär organisierten Sensor 15 kann es sich beispielsweise um ein Kontaktsystem, wie einen elektrischen Schalter, handeln, mit dessen Hilfe ein binäres Schaltsignal erzeugbar ist. Ein Beispiel für einen binär organisierten Aktor 16 ist ein Leuchtmittel, das ein binäres Schaltsignal visuell sichtbar macht. Die Buslogik 14 besteht aus einer im Sensormodul 8, 9, 10, 17, 18 befindlichen elektronischen Schaltung, mittels der das jeweilige Sensormodul 8, 9, 10, 17, 18 an den Bus 7 gekoppelt ist. Mit Hilfe der Buslogik 14 werden die binären Schaltsignale in Bussignale umgesetzt und auf den Bus 7 übertragen. Umgekehrt können die Bussignale mit Hilfe der Buslogik 14 auch vom Bus 7 aufgenommen und in binäre Schaltsignale umgesetzt werden.

Der Bus 7 besteht aus einer einzigen gemeinsamen Datenleitung 19, über die die Sensormodule 8, 9, 10, 17, 18 miteinander verbunden sind, und ist zur seriellen Datenübertragung ausgebildet. Die Sensormodule 8, 9, 10, 17, 18 sind jeweils mit einer Leitung 21 an die Spannungsversorgung und mit einer weiteren Leitung 22 an die Masse angeschlossen. Bei geringeren Anforderungen an die Datensicherheit kann die Datenleitung 19 auch von der Leitung 21 für die Spannungsversorgung gebildet werden, bevorzugt wird jedoch eine von der Leitung 21 der Versorgungsspannung getrennte Datenleitung 19. Die Datenleitung 19 wird von dem vom Hauptbus 6 unabhängigen Busmaster-Gerät 5 angesteuert. Dazu ist im Busmaster-Gerät 5 eine Buslogik-Steuerung 20, bei der es sich beispielsweise um einen Mikroprozessor oder einen Signalprozessor handeln kann, angeordnet.

Jedem Sensormodul 8, 9, 10, 17, 18 im Bussystem ist mittels der Buslogik 14 eine Adresse zuordenbar. Das Busmaster-Gerät 5 kann Bussignale entsprechend der Adresse des jeweiligen Sensormoduls 8, 9, 10, 17, 18 erzeugen, so daß das jeweilige Sensormodul 8, 9, 10, 17, 18 vom Busmaster-Gerät 5 ansprechbar ist. Umgekehrt kann das Busmaster-Gerät 5 dadurch auch erkennen, von welchem Sensormodul 8, 9, 10, 17, 18 Daten übertragen werden. Über ein dynamisches Polling kann die Priorität des Sensormodulus 8, 9, 10, 17, 18 gesteuert werden, d.h. ein Sensormodul 8, 9, 10, 17, 18 mit höherer Priorität ist wegen der direkten Adressierbarkeit mehrfach in einem Abfragezyklus vom Busmaster-Gerät 5 ansprechbar. Da die Sensormodule 8, 9, 10, 17, 18 nach jeder Abfrage mit einem Reset-Befehl zurückgesetzt werden, sind undefinierte Zustände durch Störungen auszuschließen.

Tritt eine Unterbrechung auf dem Bus 7 auf, so lassen sich die Sensormodule 8, 9, 10, 17, 18 bis zur Unterbrechung vom Busmaster-Gerät 5 abfragen. Bei einem Kurzschluß ist zwar kein Sensormodul 8, 9, 10, 17, 18 mehr abfragbar, aber es wird erkannt, daß eine Störung aufgetreten ist. Wird vom Busmaster-Gerät 5 ein bestimmtes Signal zur Buslogik 14 übertragen, wird eine Überprüfung der Funktionsfähigkeit der Buslogik 14, also ein Selbsttest, ausgelöst. Ein dem Ergebnis dieses Tests entsprechendes Signal wird dann an das Busmaster-Gerät 5 zurückgesandt, so daß das Busmaster-Gerät 5 die Funktionsfähigkeit des gesamten Busses 7 überwachen kann. Bei Ausfall einzelner Sensormodule 8, 9, 10, 17, 18 kann dann eine entsprechende Fehlermeldung angezeigt werden.

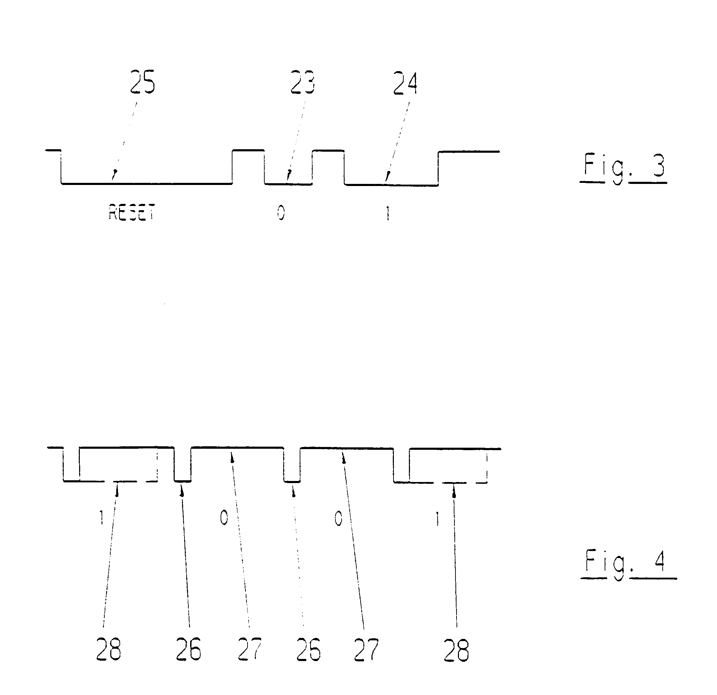

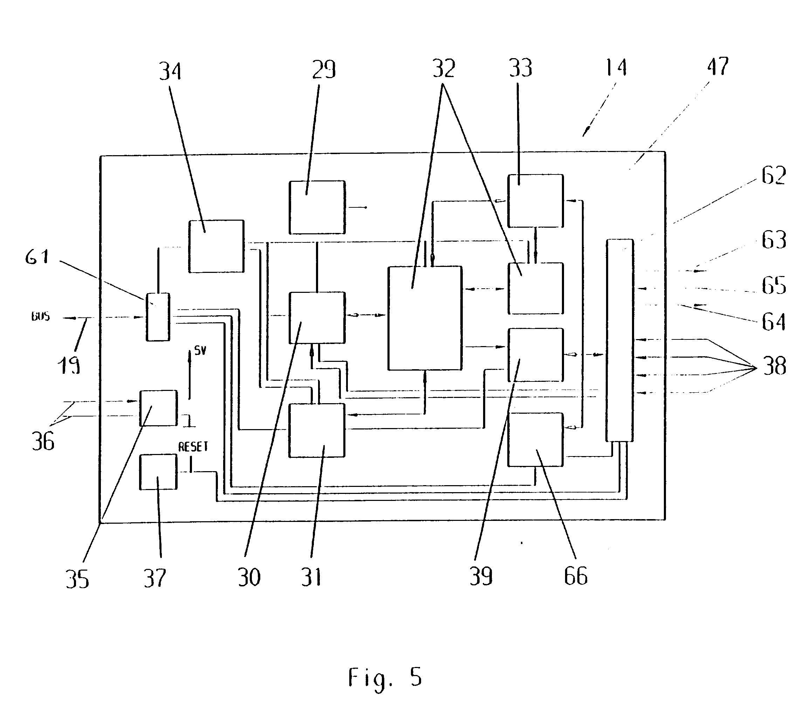

Als Übertragungsverfahren wird ein Halbduplex-Betrieb verwendet, wobei der Bus 7 auf der Datenleitung 19 sowohl in Sende- als auch in Empfangsrichtung bidirektional arbeitet. Bei der Übertragung der Bussignale vom Busmaster-Gerät 5 zum Sensormodul 8, 9, 10, 17, 18 in Senderichtung findet eine Puls/Pausen-Modulation statt, die näher in Fig. 3 gezeigt ist. Bei der Übertragung der Bussignale vom Sensormodul 8, 9, 10, 17, 18 zum Busmaster-Gerät 5 in Empfangsrichtung findet eine Belastungsmodulation statt, die näher in Fig. 4 gezeigt ist.

Wie anhand von Fig. 3 zu sehen ist, erzeugt die Buslogik-Steuerung 20 im Busmaster-Gerät 5 bei der Puls/Pausen-Modulation verschieden lange Low-Signale 23, 24, 25. Ein kurzes Low-Signal 23 interpretiert die den Empfänger darstellende Buslogik 14 im Sensormodul 8, 9, 10, 17, 18 als logische Null, ein langes Low-Signal 24 als logische Eins. Ein noch längeres Low-Signal 25 interpretiert die Buslogik 14 als Reset-Signal. Bei einem derartigen Reset-Signal wird der Anfangszustand der Buslogik 14 eingestellt. Auch bei der Belastungsmodulation übernimmt die Buslogik-Steuerung 20 die zeitliche Steuerung der Übertragung. Wie in Fig. 4 zu sehen ist, schaltet die Buslogik-Steuerung 20 im Busmaster-Gerät 5 eine Folge von High-Signalen 27 und Low-Signalen 26 auf die Datenleitung 19, wobei das High-Signal 27 zeitlich länger ist. Abhängig von den zu übertragenden Daten kann die Buslogik 14 dieses High-Signal 27 dann entweder auf High belassen oder aktiv auf Low bringen. Während die Buslogik-Steuerung 20 die Datenleitung 19 setzt, "beobachtet" diese sie und erkennt so die von der Buslogik 14 vorgenommenen Pegeländerungen, die als Signale 28 in Fig. 4 gestrichelt eingezeichnet sind. Wird eine Pegeländerung gemäß Signal 28 von der Buslogik 14 vorgenommen, so interpretiert die Buslogik-Steuerung 20 dies als logische Eins. Wird keine Pegeländerung von der Buslogik 14 vorgenommen, so daß das Signal 27 unverändert bleibt, so interpretiert die Buslogik-Steuerung 20 dies als logische Null.

Bei der im Sensormodul 8, 9, 10, 17, 18 befindlichen Buslogik 14 handelt es sich um eine elektronische Schaltung, deren näherer Aufbau in einem Blockschaltbild gemäß Fig. 5 zu sehen ist. Die Buslogik 14 besitzt einen internen Spannungswandler 35, der über elektrische Zuleitungen 36 mit den entsprechenden Leitungen 21, 22 zur Spannungsversorgung des Sensormoduls 8, 9, 10, 17, 18 verbunden ist. Da die Versorgungsspannung von der Autobatterie abgenommen wird, deren Spannung bei 12 V oder 24 V liegt, dient der Spannungswandler 35 dazu, die Versorgungsspannung auf das für die Buslogik 14 nötige Maß, beispielsweise 5 V umzuwandeln. Ein Power-On-Baustein 37 führt einen internen Reset in der Buslogik 14 automatisch nach dem Einschalten durch, so daß die Buslogik 14 in einen definierten Anfangszustand versetzt wird. Ein integrierter Oszillator 29 liefert den internen Takt für die Buslogik 14. Die Steuerung der Abläufe in der Buslogik 14 erfolgt über die Steuerungseinheit 32.

Das vom Busmaster-Gerät 5 gesendete und über die Datenleitung 19 in einem Eingangs/Ausgangs-Baustein 61 empfangene Bussignal durchläuft zunächst ein Signalfilter 34, das aus einem ersten und einem zweiten Zähler besteht. Die Buslogik 14 tastet mittels der im Oszillator 29 erzeugten Taktfrequenz über die Steuerungseinheit 32 das Datensignal ab. Ist das Datensignal auf Low, so wird der erste Zähler im Signalfilter 34 um eins erhöht. Dabei wird ein Low- oder High-Pegel nicht durch einmaliges, sondern mehrmaliges Abtasten bewertet. Kurzzeitige Störungen auf dem Datensignal wirken sich damit bei diesem Verfahren nicht aus. Sie machen sich nur dann auf dem Signal bemerkbar, wenn sie während des Abtastens auftreten. Nach erfolgreichem mehrmaligen Abtasten empfängt der zweite Zähler im Signalfilter 34 ein Reset-Signal, woraufhin der zweite Zähler zu Zählen beginnt. In Abhängigkeit vom Zählvorgang des zweiten Zählers werden dann von diesem die Zustände Null oder Eins gemäß Fig. 3 detektiert. Beim Erreichen seines Maximalstandes setzt der zweite Zähler die gesamte Buslogik 14 zurück, was dem Reset-Signal für die Buslogik 14 entspricht.

Für das Erkennen einer Null und einer Eins wird somit ein Bereich definiert, um eine Drift der Empfängerfrequenz der Buslogik 14 zuzulassen. Diese Bereiche und die Schwelle zwischen Null und Eins sind dabei so gewählt, daß eine Drift der Empfängerfrequenz für beide Daten eine gleich große Abweichung von der Nennfrequenz zuläßt. Damit bleiben Störungen auf der Datenleitung 19 weitgehend ohne Einfluß. Gegenüber herkömmlichen Verfahren bietet dieses Übertragungsverfahren den Vorteil, daß das Empfangssignal nicht statisch oder flankensensitiv bewertet, sondern abgetastet wird. Störungen machen sich also nur dann bemerkbar, wenn sie während des Abtastmoments auftreten. Der Zählvorgang blendet Störungen während des Abtastvorgangs weitgehend aus. Weiter vorteilhaft ist, daß zum Erkennen einer Eins oder einer Null keine festen Zeiten erforderlich sind, sondern ein zeitlicher Bereich genügt. Das Verfahren akzeptiert also Frequenztoleranzen bis zu 100 %.

Das aus dem Bussignal entsprechend dem zweiten Zähler im Signalfilter 34 erzeugte Datensignal wird in einem Schieberegister 30 zwischengespeichert. Über das Datensignal wird ein Kontroll-Datum, das sogenannte CRC, von einer CRC-Einheit 31 nach einem festgelegten Algorithmus gebildet. Dieses CRC wird mit dem vom Busmaster-Gerät 5 empfangenen CRC mittels der Steuerungseinheit 32 verglichen, so daß Übertragungsfehler entdeckt und die Datenübertragung gegebenenfalls wiederholt werden kann.

An dem im Schieberegister 30 befindlichen Datensignal wird weiter mittels der Steuerungseinheit 32 eine Adressendecodierung zur Ermittlung der vom Busmaster-Gerät 5 vorgesehenen Empfängeradresse vorgenommen. Die Adresse des jeweiligen Sensormoduls 8, 9, 10, 17, 18 ist beispielsweise über DIP-Schalter eingestellt und liegt an Adressenleitungen 38 an, deren Signal über einen Ausgangs/Eingangs-Baustein 62 in einen Register-Baustein 39 weiterleitbar ist. Die Steuerungseinheit 32 kann zum Adressenvergleich auf den Register-Baustein 39 zugreifen. Bei Übereinstimmung zwischen Empfängeradresse und der Adresse des Sensormoduls wird der Sensor 15 bzw. der Aktor 16 im zugehörigen Sensormodul 8, 9, 10, 17, 18 durch die Steuerungseinheit 32 aktiviert. Dazu befindet sich am Ausgangs/Eingangs-Baustein 62 eine Sensoraktivierungsleitung 63 bzw. eine Aktoraktivierungsleitung 64.

Handelt es sich um einen Sensor 15, so wird dieser für einen bestimmten Zeitraum, beispielsweise 10 µs, aktiviert. Die Aktivierungszeit wird von einem Timer-Baustein 33, der ebenfalls vom internen Oszillator 29 gesteuert wird, eingestellt. Dann wird das binäre Schaltsignal des Sensors 15, das dessem Status entspricht, nach dem Abwarten der Einschwingzeit über die Statusleitung 65 am Ausgangs/Eingangs-Baustein 62 in den Register-Baustein 39 geladen und von der Steuerungseinheit 32 ausgewertet. Ein Datensignal entsprechend dem Status des Sensors 15, ein Testflag und ein CRC-Signal, das wiederum von der CRC-Einheit 31 gebildet wird, werden dann von der Steuerungseinheit 32 im Schieberegister 30 bereitgestellt und vom Eingangs/Ausgangs-Baustein 61 über die Datenleitung 19 als Bussignale an das Busmaster-Gerät 5 übertragen, wobei die Signalübertragung als Belastungsmodulation gemäß Fig. 4 vom Busmaster-Gerät 5 gesteuert wird.

Das Busmaster-Gerät 5 kann, falls keine Übertragungen auf dem Bus 7 stattfinden, in einen Standby-Modus mit geringer Stromaufnahme schalten. Überträgt dann das Busmaster-Gerät 5 in einem bestimmten Zeitraum, beispielsweise ungefähr 15 ms, kein Signal zur Buslogik 14, so schaltet auch diese selbständig in einen stromsparenden Interrupt-Mode um. In diesem Interrupt-Mode wird in bestimmten Abständen, beispielsweise ca. 15 ms, veranlaßt durch den Timer-Baustein 33 der Sensor 15 von der Steuerungseinheit 32 aktiviert und der ermittelte Wert im Register-Baustein 39 gespeichert. Ändert sich dieser Wert innerhalb zweier Abfragen des Sensors 15, so wird vom Interrupt-Baustein 66 über den Bus 7 ein Interrupt generiert und eine entsprechende, vom Busmaster-Gerät 5 gesteuerte Signalübertragung zum Busmaster-Gerät 5 ausgelöst.

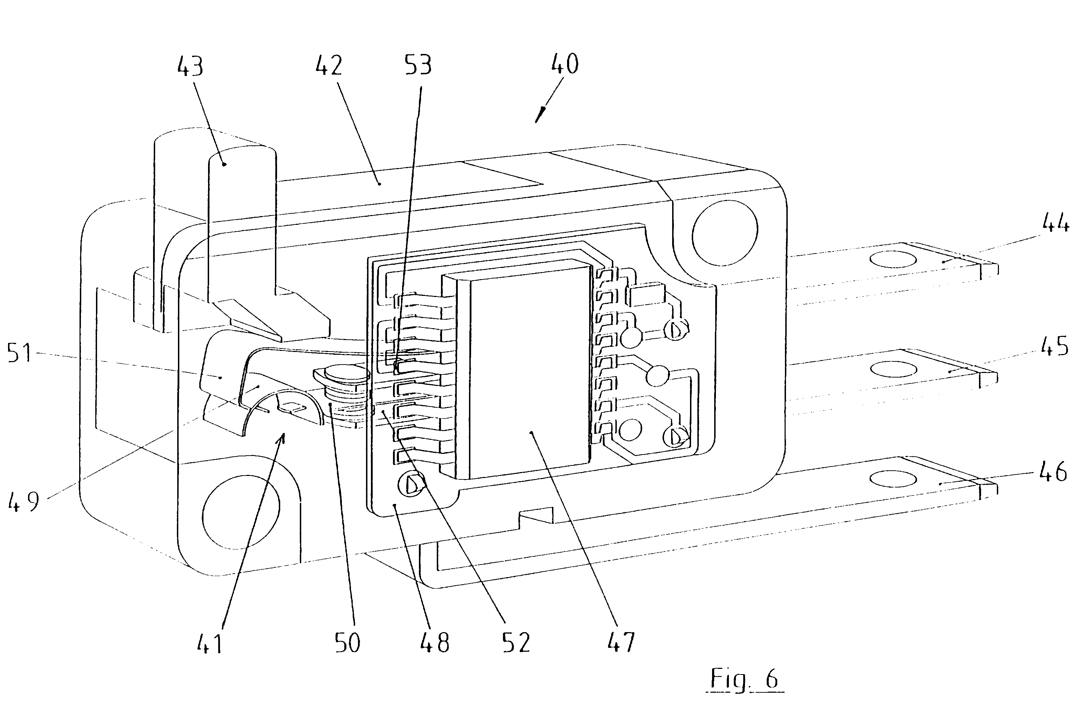

Die Schaltung gemäß Fig. 5 für die Buslogik 14 ist vorzugsweise in DMOS-Technologie als Bus-IC 47 (siehe dazu auch Fig. 6) in Form eines integrierten Bausteins auf einem Chip ausgebildet. Der Chip ist im wesentlichen ohne externe Bauelemente an die Spannungsversorgung für das Bordnetz des Kraftfahrzeugs anschließbar und es werden keine zusätzlichen Maßnahmen für die Bordnetzentkoppelung von Störspannungen benötigt. Solche Störspannungen können durch die Zündung hervorgerufene Spannungsspitzen bis zu ca. 100 V, sogenannte Load-Dumps, sein. Damit wird ein höchstmögliches Maß an Sicherheit gegen EMV-Störungen erzielt. Außerdem ist der Baustein mit einer kleinen Chipfläche realisierbar. Infolge der kleinen Leistungsaufnahme des Chips und der Taktung des eigentlichen Sensors 15 durch die Buslogik 14 über die Sensoraktivierungsleitung 63 bleibt der Stromverbrauch auf niedrigem Niveau, beispielsweise unter 500 µA.

Die nähere Ausbildung eines Sensormoduls 8, 9, 10 zur Erfassung eines binären Schaltsignals ist in einer ersten Ausführungsform in Fig. 6 zu sehen. Als Sensor 15 wird ein mechanischer Schalter 40 verwendet, wodurch ein einzelner Schalter mit einer integrierten Sensor-/Buslogik konzipiert wird, dessen Schaltsignal über den Bus 7 unmittelbar an das Busmaster-Gerät 5 und gegebenenfalls an den übergeordneten Hauptbus 6 weitergegeben wird. Hierdurch wird ein Einzelschalter in beliebiger Bauart zu einem "Busschalter" konzipiert, d. h. das Schaltelement wird "busfähig" gemacht und in einem Bussystem verwaltet.

Der Schalter 40 besitzt ein Kontaktsystem 41, das in einem Gehäuse 42 angeordnet ist. Das Gehäuse 42 besitzt mit einem herkömmlichen Mikroschalter vergleichbare äußere Abmessungen. Mit dem Kontaktsystem 41 steht ein auf das Kontaktsystem 41 schaltend einwirkendes Betätigungsorgan 43 in Wirkverbindung. Zur Versorgung des Kontaktsystems 41 mit elektrischer Spannung befinden sich am Gehäuse 42 zwei Anschlüsse 44, 45, mit denen die in Fig. 2 gezeigten Leitungen 21, 22 in elektrischem Kontakt stehen. Ein weiterer ins Innere des Gehäuses 42 reichender Anschluß 46 dient für die Verbindung mit der Datenleitung 19 für den Bus 7 zur Übertragung von Signalen. Im Gehäuse 42 ist weiter die Buslogik 14 als Chip in Form eines Bus-IC's 47 angeordnet.

Der Bus-IC 47 kann sich auf einer Platine 48 befinden. Es bietet sich dann an, das Kontaktsystem 41 derart im Gehäuse 42 anzuordnen, daß es an der Platine 48 befestigt ist. Die Platine 48 steht mit den in das Gehäuse 42 reichenden Anschlüssen 44, 45, 46 in Verbindung, wobei die Anschlüsse 44, 45 für die Spannungsversorgung des Kontaktsystems 41 und der Anschluß 46 als Datenleitung 19 dienen.

Bei dem Kontaktsystem 41 des Schalters 40 handelt es sich um ein mechanisch wirkendes Kontaktsystem, das als Schnappschaltersystem mit einem Schaltkontakt 50 und wenigsten einem, vorzugsweise zwei Festkontakten 52, 53 ausgebildet ist. Eine Rollfeder 49 ist zwischen dem beweglichen Schaltkontakt 50 und einem Federhebel 51, der wiederum mit dem Betätigungsorgan 43 in Wirkverbindung steht, eingespannt. In unbetätigtem Zustand liegt der Schaltkontakt 50 an dem Festkontakt 53 an. Durch Krafteinwirkung auf das Betätigungsorgan 43 wird der Federhebel 51 bewegt, wobei der Schaltkontakt 50 umschnappt und in Anlage an den Festkontakt 52 kommt. Bei den binären Schaltsignalen handelt es sich somit um den jeweiligen Schaltzustand des Kontaktsystems 41, nämlich einem ersten Zustand, bei dem der Schaltkontakt 50 am Festkontakt 53 anliegt und einem zweiten Zustand, bei dem der Schaltkontakt 50 am Festkontakt 52 anliegt.

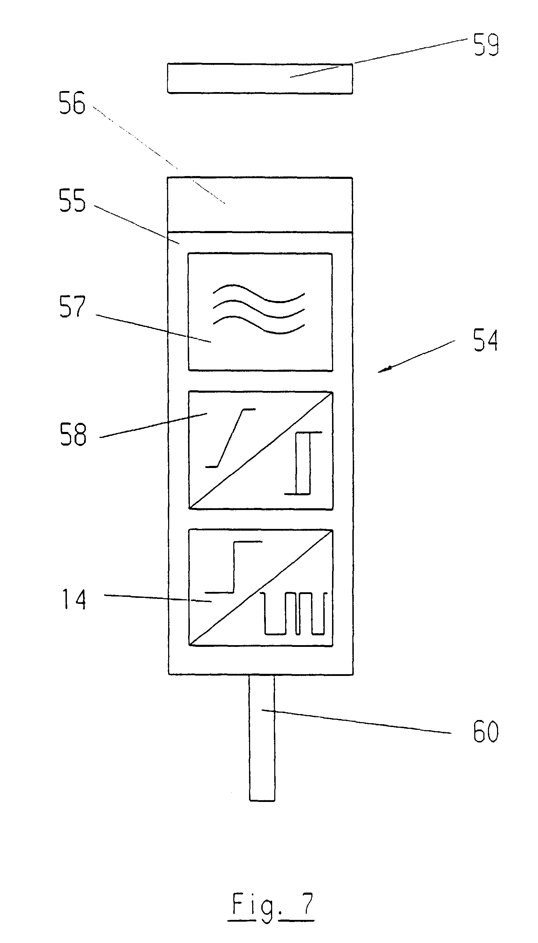

Anstelle eines derartigen Schalters 40, bei dem ein mechanisches Kontaktsystem 41 als Sensor 15 verwendet ist, läßt sich das Kontaktsystem auch als Sensor 15 mit einem anderen Wirkprinzip ausbilden. Für den Sensor 15 können beispielsweise auf dem Halleffekt basierende magnetische oder induktive, kapazititve, magnetorestriktive, optische u. dgl. Wirkprinzipien gewählt werden. In Fig. 7 ist als weiteres Ausführungsbeispiel ein Sensormodul 8, 9, 10 in Form eines Induktivsensors 54 in einem Blockschaltbild schematisch zu sehen.

Der Induktivsensor 54 besitzt ein Gehäuse 55 mit einer an der Stirnseite befindlichen aktiven Fläche 56. Im Gehäuse 55 ist ein Oszillator 57, eine Trigger-Stufe 58 sowie die Buslogik 14 angeordnet. In der Nähe der aktiven Fläche 56 befindet sich ein bewegbares Bedämpfungsstück 59, beispielsweise ein elektrisch leitendes Metall, als Betätigungsorgan. In das Gehäuse 55 führt ein mit der Buslogik 14 in Verbindung stehender Anschluß 60 für die Datenleitung 19. Die Anschlüsse für die Versorgungsspannung des Induktivsensors 54 sind der Übersichtlichkeit halber weggelassen.

Wird vom Busmaster-Gerät 5 ein Bussignal mit der dem Induktivsensor 54 zugehörigen Adresse über den Bus 7 übermittelt, so aktiviert die Buslogik 14 den Oszillator 57. Dieser erzeugt mittels einer Schwingkreisspule ein elektromagnetisches Wechselfeld, das aus der aktiven Fläche 56 des Induktivsensors 54 austritt. Nähert sich nun das Bedämpfungsstück 59 der aktiven Fläche 56, so werden in dem Bedämpfungsstück 59 Wirbelströme induziert, die dem Oszillator 57 Energie entziehen. Dadurch wird eine Pegeländerung erzielt, die ein Kippen der Triggerstufe 58 bewirkt. Das Ausgangssignal der Triggerstufe 58 wird von der Buslogik 14 erfaßt und auf Anforderung dann dem Status des Induktivsensors 54 entsprechende Bussignale an das Busmaster-Gerät 5 gesendet.

Die Erfindung ist nicht auf die beschriebenen und dargestellten Ausführungsbeispiele beschränkt. Sie umfaßt vielmehr auch alle fachmännischen Weiterbildungen im Rahmen des Erfindungsgedankens. So können das Bussystem und die daran angekoppelten Sensormodule nicht nur in Kraftfahrzeugen eingesetzt werden. Denkbar ist die Verwendung auch in Werkzeugmaschinen, wo beispielsweise die Positionsabfrage eines Betätigers bei einem Hydraulikzylinder oder die Feststellung der Endposition eines Werkstückschlittens erfolgen kann. Auch bei Meßgeräten, Prozeßsteuerungen, u. dgl. sowie für Anzeigenelemente und Motortreiber läßt sich die Erfindung vielseitig verwenden.
- 1: Steuergerät für die Motorelektronik
- 2: Motorraum
- 3: Schaltgerät für Bedienschalter
- 4: Autotür
- 5: Steuergerät für Fensterheber und Rückspiegelverstellung
- 6: Hauptbus
- 7: Bus
- 8: Sensormodul für die Rückspiegelverstellung
- 9: Sensormodul für die Zentralverriegelung
- 10: Sensormodul für die Fensterheber
- 11: Rückspiegel
- 12: Fenster
- 13: Türschloß
- 14: Buslogik
- 15: Sensor
- 16: Aktor
- 17, 18:: Sensormodul (weitere Ausführung)
- 19: Datenleitung
- 20: Buslogik-Steuerung (im Busmaster-Gerät)
- 21: Leitung für die Spannungsversorgung
- 22: Leitung für die Masse
- 23: kurzes Low-Signal (Null)
- 24: langes Low-Signal (Eins)
- 25: noch längeres Low-Signal (Reset)
- 26: Low-Signal
- 27: High-Signal
- 28: Signal (Änderung bei Belastungsmodulation)
- 29: Oszillator
- 30: Schieberegister
- 31: CRC-Einheit
- 32: Steuerungseinheit
- 33: Timer-Baustein
- 34: Signalfilter
- 35: interner Spannungswandler
- 36: elektrische Zuleitung
- 37: Power-On-Baustein
- 38: Adressenleitung
- 39: Register-Baustein
- 40: mechanischer Schalter
- 41: Kontaktsystem
- 42: Gehäuse
- 43: Betätigungsorgan
- 44, 45: Anschluß (für elektrische Spannung)
- 46: Anschluß (für Datenleitung)
- 47: Bus-IC
- 48: Platine
- 49: Rollfeder
- 50: Schaltkontakt
- 51: Federhebel
- 52, 53: Festkontakt
- 54: Induktivsensor
- 55: Gehäuse
- 56: aktive Fläche
- 57: Oszillator
- 58: Triggerstufe
- 59: Bedämpfungsstück
- 60: Anschluß (für Datenleitung)
- 61: Eingangs/Ausgangs-Baustein
- 62: Ausgangs/Eingangs-Baustein
- 63: Sensoraktivierungsleitung
- 64: Aktoraktivierungsleitung
- 65: Statusleitung
- 66: Interrupt-Baustein

## Patentansprüche

1. Bussystem, insbesondere zur Verwendung in einem Kraftfahrzeug, bestehend aus wenigstens einem Bus (7) zur Übertragung von Signalen zwischen über den Bus (7) verbundenen Sensormodulen (8,9,10,17,18) und einem Schalt- und/oder Steuergerät, wobei das Schalt und/oder Steuergerät als Busmaster-Gerät (5) für den Bus (7) zur Steuerung der Signalübertragung ausgebildet ist, und einem übergeordneten Hauptbus (6) zur Übertragung von Signalen zwischen weiteren Schaltgeräten (3) und/oder Steuergeräten (1), wobei der Bus (7) über das Busmaster-Gerät (5) mit dem Hauptbus (6) gekoppelt ist, dadurch gekennzeichnet, daß binäre Schaltsignale von dem Sensormodul (8,9,10,17,18) erfaßt und/oder verarbeitet werden, daß das Sensormodul (8,9,10,17,18) eine integrierte Buslogik (14) zur Umsetzung von binären Schaltsignalen in Bussignale und/oder zur Umsetzung von Bussignalen in binäre Schaltsignale enthält, daß die Sensormodule (8,9,10,17,18) über eine einzige gemeinsame Datenleitung (19) zur seriellen Datenübertragung im Bus (7) miteinander verbunden sind, wobei der Bus (7) auf der Datenleitung (19) sowohl in Sende- als auch in Empfangsrichtung bidirektional im Halbduplex-Betrieb arbeitet, daß die Datenleitung (19) von dem Busmaster-Gerät (5) unabhängig vom Hauptbus (6) angesteuert wird, wobei die Buslogik-Steuerung (20) im Busmaster-Gerät (5) sowohl in Sende- als auch in Empfangsrichtung die zeitliche Steuerung der Datenübertragung übernimmt, und daß ferner über den Bus (7) die Spannungsversorgung der angeschlossenen Sensormodule (8,9,10,17,18) erfolgt.

2. Bussystem nach Anspruch 1, dadurch gekennzeichnet, daß das Sensormodul (8, 9, 10, 17, 18) einen binär organisierten, zwei Statuszustände besitzenden Sensor (15) und/oder Aktor (16) besitzt.

3. Bussystem nach Anspruch 2, dadurch gekennzeichnet, daß es sich bei dem binär organisierten Aktor (16) um ein Leuchtmittel handelt.

4. Bussystem nach Anspruch 2, dadurch gekennzeichnet, daß es sich bei dem binär organisierten Sensor (15) um ein Kontaktsystem (41) handelt.

5. Bussystem nach Anspruch 4, dadurch gekennzeichnet, daß es sich bei den binären Schaltsignalen um Signale entsprechend dem Schaltzustand des Kontaktsystems (41) handelt.

6. Bussystem nach Anspruch 5, dadurch gekennzeichnet, daß das Sensormodul (8, 9, 10, 17, 18) ein Gehäuse (42) besitzt, in dessen Innerem das Kontaktsystem (41), auf das ein mit dem Kontaktsystem (41) in Wirkverbindung stehendes Betätigungsorgan (43) schaltend einwirkt, und die Buslogik (14) angeordnet sind, wobei ein ins Innere des Gehäuses (42) reichender Anschluß (46) für den Bus (7) mit der Buslogik (14) in Verbindung steht.

7. Bussystem nach Anspruch 6, dadurch gekennzeichnet, daß die Schaltung für die Buslogik (14) auf einer Platine (48) angeordnet ist.

8. Bussystem nach Anspruch 7, dadurch gekennzeichnet, daß das Kontaktsystem (41) von der Platine (48) abgeht.

9. Bussystem nach Anspruch 7 oder 8, dadurch gekennzeichnet, daß die Platine (48) mit den in das Gehäuse (42) reichenden elektrischen Anschlüssen (44, 45) und dem Anschluß (46) für die Datenleitung (19) in Verbindung steht.

10. Bussystem nach einem der Ansprüche 4 bis 9, dadurch gekennzeichnet, daß es sich bei dem Kontaktsystem des Sensormoduls (8, 9, 10, 17, 18) um ein mechanisches Kontaktsystem (41) handelt.

11. Bussystem nach Anspruch 10, dadurch gekennzeichnet, daß das Kontaktsystem (41) als Schnappschaltersystem mit einem beweglichem Schaltkontakt (50), wenigstens einem Festkontakt (52, 53) und einem Federhebel (51) ausgebildet ist, wobei zwischen dem Schaltkontakt (50) und dem Federhebel (51) eine Rollfeder (49) eingespannt ist und das Betätigungsorgan (43) mit dem Federhebel (51) in Wirkverbindung steht.

12. Bussystem nach Anspruch 11, dadurch gekennzeichnet, daß das Gehäuse (42) in Form und Größe wie ein Mikroschalter ausgebildet ist.

13. Bussystem nach einem der Ansprüche 4 bis 9, dadurch gekennzeichnet, daß es sich bei dem Kontaktsystem des Sensormoduls (8, 9, 10, 17, 18) um ein induktiv, kapazitiv, magnetorestriktiv, optisch oder magnetisch mittels HallEffekt arbeitendes Kontaktsystem handelt.

14. Bussystem nach Anspruch 13, dadurch gekennzeichnet, daß das Sensormodul als Induktivsensor (54) ausgebildet ist, indem in einem Gehäuse (55) ein mit einer Schwingkreisspule in Verbindung stehender Oszillator (57), eine Triggerstufe (58) und die Buslogik (14) angeordnet sind, wobei mittels der Schwingkreisspule ein über eine aktive Fläche (56) aus dem Gehäuse (55) austretendes Wechselfeld erzeugbar ist und ein als Betätigungsorgan dienendes Bedämpfungsstück (59) in die Nähe der aktiven Fläche (56) bewegbar ist.

15. Bussystem nach einem der Ansprüche 1 bis 14, dadurch gekennzeichnet, daß die Schaltung für die Buslogik (14) als Bus-IC (47) in Form eines integrierten Bausteins ausgebildet ist.

16. Bussystem nach Anspruch 15, dadurch gekennzeichnet, daß es sich beim Bus-IC (47) um einen in DMOS-Technologie ausgebildeten Baustein handelt.

17. Bussystem nach Anspruch 1, dadurch gekennzeichnet, daß es sich bei der Datenleitung um die Leitung (21) der Spannungsversorgung des Sensormoduls (8, 9, 10, 17, 18) handelt.

18. Bussystem nach Anspruch 1, dadurch gekennzeichnet, daß es sich bei der Datenleitung um eine von der Versorgungsspannung getrennte Leitung (19) zum Sensormodul (8, 9, 10, 17, 18) handelt.

19. Bussystem nach Anspruch 1, 17 oder 18, dadurch gekennzeichnet, daß die Bussignale in Senderichtung vom Busmaster-Gerät (5) zum Sensormodul (8, 9, 10, 17, 18) mit einer Puls/Pausen-Modulation und in Empfangsrichtung vom Sensormodul (8, 9, 10, 17, 18) zum Busmaster-Gerät (5) mit einer Belastungsmodulation übertragbar sind.

20. Bussystem nach Anspruch 19, dadurch gekennzeichnet, daß das Busmaster-Gerät (5) bei der Puls/Pausen-Modulation verschieden lange Low-Signale (23, 24, 25) erzeugt, wobei ein kurzes Low-Signal (23) als Null, ein langes Low-Signal (24) als logische Eins und ein noch längeres Low-Signal (25) als Reset von der Buslogik (14) des Sensormoduls (8, 9, 10, 17, 18) interpretiert wird.

21. Bussystem nach Anspruch 19 oder 20, dadurch gekennzeichnet, daß das Busmaster-Gerät (5) bei der Belastungsmodulation eine Folge von High-Low-High-Pegeln (26, 27) auf der Datenleitung (19) erzeugt, wobei der High-Pegel (27) eine längere Zeit auf High ist, die Buslogik (14) des Sensormoduls (8, 9, 10, 17, 18) das Bussignal abhängig von den zu übertragenden Daten auf High beläßt oder aktiv auf Low bringt und das Busmaster-Gerät (5) die von der Buslogik (14) des Sensormoduls (8, 9, 10, 17, 18) vorgenommenen Pegeländerungen an den Signalen (28) auswertet.

22. Bussystem nach Anspruch 19, 20 oder 21, dadurch gekennzeichnet, daß die Buslogik (14) des Sensormoduls (8, 9, 10, 17, 18) das Bussignal mit einer bestimmten Taktfrequenz abtastet und einen Low- oder High-Pegel durch mehrmaliges Abtasten bewertet.

23. Bussystem nach einem der Ansprüche 1 bis 22, dadurch gekennzeichnet, daß mittels der Buslogik (14) dem Sensormodul (8, 9, 10, 17, 18) eine Adresse zuordenbar und Bussignale entsprechend der Adresse des Sensormoduls (8, 9, 10, 17, 18) erzeugbar sind.

24. Bussystem nach einem der Anspruch 1 bis 23, dadurch gekennzeichnet, daß durch ein Bussignal die Überprüfung der Funktionsfähigkeit der Buslogik (14) entsprechend eines Selbsttests auslösbar ist.

## Claims

1. Bus system, in particular for use in a motor vehicle, comprising at least one bus (7) for the transmission of signals between sensor modules (8, 9, 10, 17, 18) connected via the bus (7) and a switching and/or control device, whereby the switching and/or control device is provided in the form of a master device (5) for the bus (7) for control of the signal transmission, and comprising a higher ranking main bus (6) for the transmission of signals between further switching devices (3) and/or control devices (1), whereby the bus (7) is coupled to the main bus (6) via the bus master device (5), characterised in that binary switching signals are detected and/or processed by the sensor module (8, 9, 10, 17, 18), that the sensor module (8, 9, 10, 17, 18) contains an integrated bus logic (14) for conversion of the binary switching signals into bus signals and/or for conversion of bus signals into binary switching signals, that the sensor modules (8, 9, 10, 17, 18) are connected to one another via a single joint data line (19) for serial data transmission in the bus (7), whereby the bus (7) operates bi-directionally in half-duplex operation on the data line (19) both in transmitting direction and in receiving direction, that the data line (19) is actuated by the bus master device (5) independently of the main bus (6), whereby the bus logic control (20) in the bus master device (5) assumes the time control of the data transmission both in transmitting direction and in receiving direction, and that moreover the connected sensor modules (8, 9, 10, 17, 18) are supplied with voltage via the bus (7).

2. Bus system according to Claim 1, characterised in that the sensor module (8, 9, 19, 17, 18) has a binary organised sensor (15) and/or actuator (16) having two statuses.

3. Bus system according to Claim 2, characterised in that the binary organised actuator (16) is an illumination means.

4. Bus system according to Claim 2, characterised in that the binary organised sensor (15) is a contact system (41).

5. Bus system according to Claim 4, characterised in that the binary switching signals are signals in keeping with the switching status of the contact system (41).

6. Bus system according to Claim 5, characterised in that the sensor module (8, 9, 10, 17, 18) has a housing (42), in the interior of which the contact system (41), on which an operating member (43) in active connection with the contact system (41) acts for switching purposes, and the bus logic (14) are arranged, whereby a connection (46) for the bus (7) extending into the interior of the housing (42) connects to the bus logic (14).

7. Bus system according to Claim 6, characterised in that the circuit for the bus logic (14) is arranged on a board (48).

8. Bus system according to Claim 7, characterised in that the contact system (41) goes out from the board (48).

9. Bus system according to Claim 7 or 8, characterised in that the board (48) connects to the electrical connections (44, 45) extending into the housing (42) and the connection (46) for the data line (19).

10. Bus system according to one of Claims 4 to 9, characterised in that the contact system of the sensor module (8, 9, 10, 17, 18) is a mechanical contact system (41).

11. Bus system according to Claim 10, characterised in that the contact system (41) is constructed as a snap-action switch system with a movable switching contact (50), at least one fixed contact (52, 53) and a spring lever (51), whereby a scroll spring (49) is clamped between the switching contact (50) and the spring lever (51) and the operating member (43) stands in active connection with the spring lever (51).

12. Bus system according to Claim 11, characterised in that the housing (42) is constructed like a micro-switch with respect to its size and shape.

13. Bus system according to one of Claims 4 to 9, characterised in that the contact system of the sensor module (8, 9, 10, 17, 18) is a contact system operated inductively, capacitively, optically or magnetically by means of the Hall effect.

14. Bus system according to Claim 13, characterised in that the sensor module is constructed as an inductive sensor (54) by arranging an oscillator (57) connecting to a resonant circuit coil, a trigger stage (58) and the bus logic (14) in a housing (55), whereby an alternating field discharging from the housing (55) via an active face (56) may be generated by means of the resonant circuit coil, and a damping part (59) acting as operating member may be moved into the vicinity of the active face (56).

15. Bus system according to one of Claims 1 to 14, characterised in that the circuit for the bus logic (14) is constructed as a bus integrated circuit (47) in the form of an integrated module.

16. Bus system according to Claim 15, characterised in that the bus integrated circuit (47) is a module constructed in DMOS technology.

17. Bus system according to Claim 1, characterised in that the data line is the line (21) for the supply of voltage of the sensor module (8, 9, 10, 17, 18).

18. Bus system according to Claim 1, characterised in that the data line is a line (19) to the sensor module (8, 9, 10, 17, 18) separate from the voltage supply.

19. Bus system according to Claim 1, 17 or 18, characterised in that the bus signals may be transmitted in transmitting direction from the bus master device (5) to the sensor module (8, 9, 10, 17, 18) with pulse/pause modulation and in receiving direction from the sensor module (8, 9, 10, 17, 18) to the bus master device (5) with load modulation.

20. Bus system according to Claim 19, characterised in that in the case of pulse/pause modulation, the bus master device (5) generates low signals (23, 24, 25) of different length, whereby a short low signal (23) is interpreted as zero, a long low signal (24) as logic one and a still longer low signal (25) as reset by the bus logic (14) of the sensor module (8, 9, 10, 17, 18).

21. Bus system according to Claim 19 or 20, characterised in that in the case of load modulation, the bus master device (5) generates a sequence of high-low-high levels (26, 27) on the data line (19), whereby the high level (27) is on high for a relatively long period, the bus logic (14) of the sensor module (8, 9, 10, 17, 18) leaves the bus signal on high in dependence on the data to be transmitted or brings it actively to low, and the bus master device (5) evaluates the changes in level undertaken by the bus logic (14) of the sensor module (8, 9, 10, 17, 18) at the signals (28).

22. Bus system according to Claim 19, 20, or 21, characterised in that the bus logic (14) of the sensor module (8, 9, 10, 17, 18) scans the bus signal with a specific clock frequency and evaluates a low or high level by multiple scanning.

23. Bus system according to one of Claims 1 to 22, characterised in that an address may be allocated to the sensor module (8, 9, 10, 17, 18) by means of the bus logic (14) and bus signals can be generated in accordance with the address of the sensor module (8, 9, 10, 17, 18).

24. Bus system according to one of Claims 1 to 23, characterised in that monitoring of the operating capability of the bus logic (14) according to an automatic check may be triggered by a bus signal.

## Revendications

1. Système de bus, notamment destiné à être utilisé dans un véhicule automobile, constitué par au moins un bus (7) servant à transmettre des signaux entre des modules de capteurs (8, 9, 10, 17, 18) reliés par l'intermédiaire du bus (7) et un appareil de commutation et/ou de commande, l'appareil de commutation et/ou de commande étant agencé sous la forme d'un appareil (5) qui est le maître du bus (7) pour la commande de la transmission de signaux, et un bus principal de rang supérieur (6) pour transmettre des signaux entre d'autres appareils de commutation (3) et/ou appareils de commande (1), le bus (7) étant couplé au bus principal (6) par l'intermédiaire de l'appareil (5) qui est le maître du bus, caractérisé en ce que des signaux de commutation binaires sont détectés et/ou traités par le module de capteur (8, 9, 10, 17, 18), que le module de capteur (8, 9, 10, 17, 18) contient une logique intégrée de bus (14) pour convertir des signaux binaires de commutation en des signaux du bus et/ou pour convertir des signaux du bus en des signaux binaires de commutation, que les modules de capteurs (8, 9, 10, 17, 18) sont reliés entre eux par l'intermédiaire d'une seule ligne commune (19) de transmission de données, pour la transmission en série de données dans le bus (7), le bus (7) travaillant avec la ligne (19) de transmission de données d'une manière bidirectionnelle selon le fonctionnement semi-duplex aussi bien dans le sens de l'émission que dans le sens de la réception, que la ligne (19) de transmission de données est commandée par l'appareil (5), qui est maître du bus, indépendamment du bus principal (6), l'unité de commande (20) de la logique du bus située dans l'appareil (5), qui est le maître du bus, assumant aussi bien dans le sens de l'émission que dans le sens de la réception la commande dans le temps de la transmission de données, et qu'en outre l'alimentation en tension des modules de capteurs raccordés (8, 9, 10, 17, 18) est réalisée par l'intermédiaire du bus (7).

2. Système de bus selon la revendication 1, caractérisé en ce que le module de capteur (8, 9, 10, 17, 18) est un capteur (15) et/ou un actionneur (16), qui est organisé en binaire et possède deux états.

3. Système de bus selon la revendication 2, caractérisé en ce qu'en ce qui concerne l'actionneur (16) organisé en binaire, il s'agit d'un moyen d'éclairement.

4. Système de bus selon la revendication 2, caractérisé en ce qu'en ce qui concerne le capteur (15) organisé en binaire, il s'agit d'un système à contacts (41).

5. Système de bus selon la revendication 4, caractérisé en ce qu'en ce qui concerne les signaux binaires de commutation, il s'agit de signaux correspondant à l'état de commutation du système à contacts (41).

6. Système de bus selon la revendication 5, caractérisé en ce que le module de capteur (8, 9, 10, 17, 18) possède un boîtier (42), à l'intérieur duquel sont disposés le système à contacts (41), sur lequel un organe d'actionnement (43), qui coopère avec le système à contacts (41), agit de manière à produire une commutation, et la logique (14) du bus, tandis qu'une borne (46), qui pénètre à l'intérieur du boîtier (42), pour le bus (7) est reliée à la logique (14) du bus.

7. Système de bus selon la revendication 6, caractérisé en ce que le circuit pour la logique (14) du bus est disposé sur une platine (48).

8. Système de bus selon la revendication 7, caractérisé en ce que le système à contacts (41) s'étend à partir de la platine (48).

9. Système de bus selon la revendication 7 ou 8, caractérisé en ce que la platine (48) est reliée aux bornes électriques (44, 45), qui pénètrent dans le boîtier (42), et à la borne (46) pour la ligne (19) de transmission de données.

10. Système de bus selon l'une des revendications 4 à 9, caractérisé en ce qu'en ce qui concerne le système à contacts du module de capteur (8, 9, 10, 17, 18), il s'agit d'un système mécanique à contacts (41).

11. Système de bus selon la revendication 10, caractérisé en ce que le système à contacts (41) est agencé sous la forme d'un système de commutateur à déclic comportant un contact mobile de commutation (50), au moins un contact fixe (52, 53) et un levier formant ressort (51), un ressort coudé (49) étant serré entre le contact de commutation (50) et le levier formant ressort (51), tandis que l'organe d'actionnement (43) coopère avec le levier formant ressort (51).

12. Système de bus selon la revendication 11, caractérisé en ce que le boîtier (42) est agencé, du point de vue forme et dimensions, comme un micro-interrupteur.

13. Système de bus selon l'une des revendications 4 à 9, caractérisé en ce qu'en ce qui concerne le système de contacts du module de capteur (8, 9, 10, 17, 18), il s'agit d'un système à contacts qui travaille de façon inductive, capacitive, magnétostrictive, optique ou magnétique à l'aide de l'effet Hall.

14. Système de bus selon la revendication 13, caractérisé en ce que le module de capteur est agencé sous la forme d'un capteur inductif (54), par le fait que dans un boîtier (55) sont disposés un oscillateur (57), qui est relié à une bobine de circuit oscillant, un étage déclencheur (58) et la logique de bus (14), un champ alternatif sortant du boîtier (55) par une surface active (56) pouvant être produit à l'aide de la bobine de circuit oscillant, et un élément d'amortissement (59), utilisé comme organe d'actionnement, pouvant être déplacé à proximité de la surface active (56).

15. Système de bus selon l'une des revendications 1 à 14, caractérisé en ce que le circuit pour la logique de bus (14) est agencé en tant que circuit intégré IC de bus (47) sous la forme d'un module intégré.

16. Système de bus selon la revendication 15, caractérisé en ce qu'en ce qui concerne le circuit intégré IC (47), il s'agit d'un module agencé selon la technologie DMOS.

17. Système de bus selon la revendication 1, caractérisé en ce qu'en ce qui concerne la ligne de transmission de données, il s'agit de la ligne (21) d'alimentation en tension du module de capteur (8, 9, 10, 17, 18).

18. Système de bus selon la revendication 1, caractérisé en ce qu'en ce qui concerne la ligne de transmission de données, il s'agit d'une ligne (19), qui est séparée de la tension d'alimentation et est reliée au module de capteur (8, 9, 10, 17, 18).

19. Système de bus selon la revendication 1, 17 ou 18, caractérisé en ce que les signaux du bus peuvent être transmis dans le sens de l'émission par l'appareil (5) qui est le maître du bus, au module de capteur (8, 9, 10, 17, 18) au moyen d'une modulation impulsion/pause et, dans le sens de la réception, par le module de capteur (8, 9, 10, 17, 18) en direction de l'appareil (5) qui est le maître du bus, au moyen d'une modulation de charge.

20. Système de bus selon la revendication 19, caractérisé en ce que l'appareil (5), qui est le maître du bus, produit, dans le cas de la modulation impulsion/pause, des signaux à niveau bas (23, 24, 25) de différentes longueurs, un bref signal à niveau bas (23) étant interprété en tant que zéro, un long signal à niveau bas (24) étant interprété en tant que un logique et un signal plus long à niveau bas (25) étant interprété en tant que remise à l'état initial de la logique de bus (14) du module de capteur (8, 9, 10, 17, 18).

21. Système de bus selon la revendication 19 ou 20, caractérisé en ce que l'appareil (5), qui est le maître du bus, produit, dans le cas de la modulation de charge, une succession de niveaux haut-bas-haut (26, 27) dans la ligne (19) de transmission de données, le niveau haut (27) étant pendant une plus longue durée au niveau haut, la logique de bus (14) du module de capteur (8, 9, 10, 17, 18) laissant le signal du bus au niveau haut de façon dépendant des données à transmettre ou l'amenant au niveau bas de façon active, et l'appareil (5), qui est le maître du bus, exploitant les variations de niveau dans les signaux (28), qui sont effectuées par la logique de bus (14) du module de capteur (8, 9, 10, 17, 18).

22. Système de bus selon la revendication 19, 20 ou 21, caractérisé en ce que la logique de bus (14) du module de capteur (8, 9, 10, 17, 18) explore le signal de bus avec une fréquence de cadence déterminée et évalue un niveau bas ou un niveau haut au moyen d'une exploration réitérée plusieurs fois.

23. Système de bus selon l'une des revendications 1 à 22, caractérisé en ce qu'au moyen de la logique de bus (14), une adresse peut être associée au module de capteur (8, 9, 10, 17, 18) et des signaux du bus peuvent être produits en fonction de l'adresse du module de capteur (8, 9, 10, 17, 18).

24. Système de bus selon l'une des revendications 1 à 23, caractérisé en ce que le contrôle de l'aptitude au fonctionnement de la logique de bus (14) peut être déclenché par un signal du bus, conformément à un test automatique.
